(19) Europäisches Patentamt
European Patent Office
Office européen des brevets

(11) Publication number: **0 421 040 A1**

(12) # EUROPEAN PATENT APPLICATION

(21) Application number: **89810750.3**

(22) Date of filing: **04.10.89**

(51) Int. Cl.5: **C23C 14/20**, C23C 14/58, H01G 1/01, H01G 4/24

(43) Date of publication of application: **10.04.91 Bulletin 91/15**

(84) Designated Contracting States: **AT BE CH DE ES FR GB GR IT LI LU NL SE**

(71) Applicant: **ENGINEERING FILMS-ESTABLISHMENT**
**Aeulestrasse 80**
**Vaduz(LI)**

(72) Inventor: **Mosca Tenna, Giovanni**
**Elektrastrasse 38**
**W-8000 München 81(DE)**

(74) Representative: **Pozzoli, Giuliano**
**e/o ENGIMPEX S.A. Industrial Property Services Dept. P.O. Box 12**
**CH-6924 Lugano-Sorengo(CH)**

(54) **Dielectric metallized plastic films, particularly for electrodes for capacitors.**

(57) The films subject of the invention include a pellicle (1) in plastic material, a metallic layer (2) laid down on at least one side of said pellicle (1), a thin layer of fluid (3, 13) able to penetrate through the roughnesses (11) of said pellicle (1).

The contact and the deposit of air and moisture through the interstices created by the particles(11) of the metal laid down through the roughnesses (11) of the pellicle is in this way avoided and furthermore the metallic layer is already fixed on metallizing.

The capacitors obtained by means of these films show characteristics of long life and lack of catastrophic failures for oxidation of the plates and furthermore unlike those of the known technique they maintain or even exceed the standard capacitance requirements avoiding the capacitance loss during the operation or storage

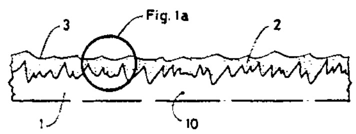


Fig. 1

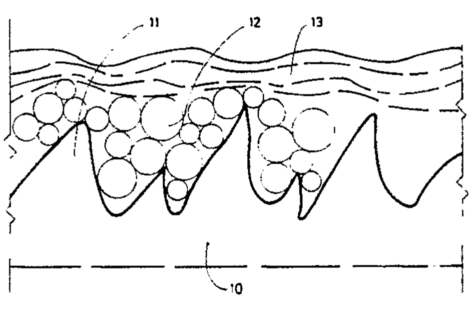


Fig. 1a

EP 0 421 040 A1

# DIELECTRIC METALLIZED PLASTIC FILMS, PARTICULARLY FOR ELECTRODES FOR CAPACITORS

The present invention refers to metallized plastic films and to one of their manufacturing processes.

These films are mainly used in the production of the electrodes for AC capacitors and find also use in the production of packing material.

It is well known that one of the most important problems of the capacitors is related to the loss of capacitance as time passes. This drawback increases as time passes, is more evident in the Aluminum-metallized capacitors and comes mainly from the presence of air on the plates, which for ionizing effect destroies the metal, causing the loss of capacitance.

To cure this drawback, it was tought to avoid the contact with the air by means of a fluid with high dielectric characteristics, which reduces to negligeable values the loss of capacitance by avoiding the ionizing effect.

The aim was reached by evaporating a fluid on the film already during the metallization process under vacuum, which penetrates into the roughnesses of the surface of the dielectric and into the interstices between metal and dielectric, covers the metal itself and creates on the same a layer able to avoid that during the subsequent working there is contact with the air.

The capacitor industry struggles between the more and more stringent standards and requirements on one hand and the cost considerations on the other hand.

They tried to exceed the specified standards by the use of Aluminum electrodes.

In general terms cost savings per microfaraday of capacitance were achieved by means of an increase of the dielectric stress.

If for instance a capacitor using an 8 micron thick dielectric could be made by a 7 micron dielectric, the dielectric stress would increase by 14% whereas the quantity of material and the cost would decrease by 24%.

Although the dielectric can well withstand the increased stress, the electrode is subject to a significantly increased attack by corona discharges which occur at these higher levels of electric field above the corona start voltage (CSV).

The main qualities sought by the manufacturers of these improved electrodes include small capacitance change during their life, low increase of the dissipation factor (DF), good clean self-regeneration (discharge/regeneration), good handling at winding, long storage capability without reduction of the performance characteristics.

Recently electrodes made primarly by Aluminum with small additions of other elements like Iron, Copper, Titanium, Carbon, Chromium have been proposed as improvement to the standards of the pure Aluminum electrodes.

Each of them was more or less accepted, but each suffered from the dilemma of obtaining an improvemrnt of the fulfilment of one set of requirements only to the detriment of the fulfilment of other requirements.

The commercially available Zinc electrodes or Zinc-Aluminum "alloyed" electrodes have achieved a lower capacitance loss because when Zinc oxidizes due to corona discharge or moisture the resulting $ZnO_2$ forms a semiconductor and not an insulator as in the case of the Aluminum oxide $Al_2O_3$.

Unfortunately the $ZnO_2$ semiconductor, which reduces the capacitance loss in the Zinc electrodes or alloyed electrodes, causes increased damages to the dielectric when self-degenerating because the $ZnO_2$ remains a partial conductor and usually doesn't clear itself cleanly with the minimum of energy as Aluminum does. Furthermore the Aluminum forms a self-protective oxide and unfortunately the Zinc doesn't.

As result any moisture will diffuse through the electrode and oxidize the Zinc and the alloy completely.

A pure Zinc electrode will fully oxidize within a few days at ambient conditions while the alloy may take weeks or more. To extend usability and storage life, thicker electrodes are built up, but this just worsens the problem of the self regeneration and leads to an early wear and to catastrophic failures like short-circuits.

In order to meet the peculiar needs and requirements of the different customers, the applicant has developed alternatives to the standard Aluminum electrodes.

Unlike the Zinc electrodes and the alloyed electrodes, the unique electrodes of the applicant achieve the lower capacitance change required by the design with increased dielectric stress, retaining at the same time good self-regeneration, operation and storage characteristics at least as the standard Aluminum.

The main products subject of the present invention are the following:

- Aluminum

Standard high-purity Aluminum, used in DC and AC applications, with flat profile (without thick edge).

- Super Aluminum (SAL)

High-purity Aluminum with dopants used in a special process which "fixes" the Aluminum during the metallization and reduces the effect of the surface roughness which promotes the oxidation in the presence of corona discharge and moisture.
The product of the invention uses a flat thickness profile and provides a lower capacitance change during the life of the capacitor compared to the standard Aluminum.
Because the Super Aluminum doesn't include Zinc or Copper in noteworthy quantities, the user can benefit by an improved life without concerns of oxidation in non-hermetically sealed constructions such as bare, wrapped box constructions.
Abnormally large deviations weren't found in the tests performed on Super Aluminum capacitors and any catastrophic failure didn't happen in the relevant tests.

- Composite (CX)

The composite electrode of the applicant isn't an alloy in the sense of the other commercially available products, where Zinc is mixed through the electrode making the whole electrode subject to oxidation.
The composite electrode of the applicant is actually a sandwich structure having a number of layers of pure or slightly doped metals in which each type of material and the relevant tickness are optimized to provide the best balance of characteristics.
In this composite structure, the Zinc layer which provides a long life capacitance performance is inserted within a multi-layer structure where a polypropylene film substrate provides a first barrier to the penetration of oxygen and moisture and an impermeable layer of alloy on the top provides another barrier. Protected from oxidation in this way, the Zinc layer can be made very thin for good self-regeneration without affecting its operation and storage characteristics.
To date capacitors with this kind of film, which were tested after one year storage in standerd plastic wrappers at ambient conditions, didn't show any appreciable degradation of their characteristics and performances.
To assure the most consistent quality of the edge connection for the various processes of spray finishing or final assembly used by the customers, the electrodes of the applicant are provided with a thick edge having a resistivity of 2-3 ohm per square unit. This provides for an edge connection which can withstand high impulse currents such as those experienced during the starting (switch-on) or connection/disconnection operations, providing at the same time an active surface having a relatively high resistivity of 5-10 ohm per square unit, which will self-regenerate easily.
Tests made in different conditions demonstrate the high AC life performances of the composite films. (see table A).

- Super composite (SCX)

This product is similar to the standard composite in the same way as the Super Aluminum is similar to the Aluminum, because the process and materials used to make Super Aluminum can be applied to the composite electrode to obtain an improved version of this excellent product.
The relevant performances are indicated by the change of capacitance shown in the following test results:
Metallized polypropylene, 8 micron, 560 VAC, 85 °C 660 hrs
AL - 2.2%
SAL - 0.72%
CX - 0.38%
SCX - 0.04%

TABLE A

| TEST RESULTS | | | | | |
|---|---|---|---|---|---|
| CONSTRUCTION | TEST CONDITIONS | ACV/MIC | HOURS | C% | FAILURES |
| 40uf, 6 x 75, I | 560 VAC - 70 °C | 93.3 | 1000 | -0.68 | 0/9 |
| 32uf, 6 x 75, I | 560 VAC - 85 °C | 93.3 | 2000 | -1.07 | 1/12 at 16 hrs |
| 22uf, 8 x 75, I | 560 VAC - 85 °C | 70.0 | 2000 | -0.88 | 0/12 |
| 14uf, 8 x 75, I | 585 VAC - 85 °C | 73.1 | 2000 | -0.71 | 0/9 |
| 14uf, 8 x 75, I | 500 VAC - 70 °C | 62.5 | 500 | -0.13 | 0/9 |
| 7uf, 8 x 75, I | 560 VAC - 80 °C | 70.0 | 1000 | -0.36 | 0/9 |
| 7uf, 8 x 75, I | 650 VAC - 80 °C | 81.2 | 1000 | -0.94 | 0/8 |
| 10uf, 8 x 75, I | 550 VAC - 80 °C | 68.8 | 1600 | -1.33 | 0/12 |
| 50uf, 8 x 100, D | 560 VAC - 85 °C | 70.0 | 1500 | -0.58 | 0/10 |
| 5uf, 6 x 50, D | 300 VAC - 90 °C | 50.0 | 2000 | -1.27 | 0/10 |
| 5uf, 7 x 50, D | 370 VAC - 90 °C | 52.9 | 2500 | -1.61 | 0/10 |
| where: I = impregnated<br>D = dry construction | | | | | |

More precisely the present invention refers to metallized plastic films, characterized by the fact that they include a plastic pellicle; a metallic layer laid down on at least one side of said pellicle; a thin layer of fluid able to penetrate through the roughnesses of said pellicle to avoid the contact and the deposit of air and moisture through the interstices created by the particles of said metal laid down through the roughnesses of said pellicle and to fix the metallic layer already on metallizing.

Furthemore an essential part of this invention is a process to realize metallized dielectric plastic films, characterized by the fact that it includes the following phases:

a) in a vacuum chamber a pellicle is unwound from at least 1 first supporting roller through a reference roller, which supports said pellicle during the metallization and the evaporation of the fluid, to be rewound by at least 1 second supporting roller;

b) by means of at least one melting device the metals for the metallization are melted, they vaporize under vacuum and condense fully or partially on at least one side of said pellicle leaving well delimited zones, suitably shielded, without metallization;

c) an evaporator including at least one nozzle delivers an oil layer over the whole useable lenght of the film on metallizing to fix the metal and to fill up with the partioles of the said metal the empty interstices created by the roughnesses of the pellicle.

We give in the following a detailed description of the invention according to a preferred (moreover not limiting) form of execution, with reference to the figures of the attached drawings:

- The figure 1 shows an enlarged view of the metallized plastic film with the covering oil layer.
- The figure 1a shows a big enlargement of a sector of the film of figure 1, with reference to the roughness of the plastic firm, to the laid down metal particles and to the thin layer of fluid penetrating into the interstices and covering the metal.
- The figure 2 shows the device which carries out the manufacturing process of the film subject of the invention.
- The figures 3a and 3b show the nozzle/tank containing the covering oil and the film obtained in this way.
- The figure 4a and 4b show another form of execution of the nozzle/tank by sector and the corresponding film obtained, covered by the protective thin layer of oil leaving however free well delimited zones.
- The figure 5 shows the feeding and heating scheme of the oil in the nozzle/tank.

The product of the invention consist of a plastic pellicle (1) having enough roughness, a layer of metal (2) laid down on at least one side of said pellicle and a thin covering layer of oil (3, 13) which penetrates into the interstices between the roughnesses (11) of the pellicle (10) and the metal particles (12) (see respectively figure 1 and figure 1a).

The pellicle must be rough in order to obtain a first-rate film on which the metal lies down easily. In the case of polyester such roughness comes from thermal and/or mechanical effect since its production. In the

case of polypropylene the roughness can be obtained by means of a previous corona treatment on the film to make the film suitable to receive the metal; said treatment consists of passing the film near a high-voltage bar, therefore by the ionic bombardment on the film surface pockmark are created which create the roughnesses and allow the easy adhesion of the afterwards laid down metal (film bathing).

This effect is then due to the bombardment on the film surface of the gaseous ions of the air ionized by the electric field.

By the use of the protective covering oil not only very small losses of capacitance are obtained in the electrodes or plates made by such films, but even capacitance increases with reference to the predetermined standard (approx. 1.3% with reference to the air capacitance = 1).

The metallic layer can be made by Aluminum or Super Aluminum, Zinc or Super Zinc, composite or super composite as described above.

The oil used has a high chemical and thermal stability, isn't inflammable, is compatible with the plastic material in a large range of temperatures, belongs to the family of the perfluoridized polyethers of general formula:

(I) $CF_3$ - ((O -

$CF_3$
|
CF -

- $CF_2)_m$ - (O - $CF_2)_n$) - O-$CF_3$
where m,n = 40.

The films can be fully metallized over the whole lenght of the band or show well delimited zones without metallization because of the oil layer laid down on the zones which must not be metallized. In this case the film is damped by oil on the relevant parts even before the metallization by means of a device not shown in the figures.

The oil (3) is heated in a tank (31, 41) by means of a resistor (50), fed by 48 VAC, with earthed pole.

The oil (3) in said tank/nozzle is maintained at constant level at the level of the leak(s) (32, 42) by means of another tank (53) connected to this through the needle valve (54).

It was found, experimentally, that the dissipation of the resistor, for the specified voltage and 400 cc of oil, is substantially equal to the useable width of the foil obtained.

A thermostat (52), connected to the resistor circuit, maintains the temperature around the optimum value for the evaporation of the oil (figure 5).

According to the invention also the choice of the type of oil to be used turned out to be very important.

It was chosen an oil of the family of the perfluoridized polyethers of general formula (I) called Fomblin (trade mark of Monteflous) which includes Carbon, Oxygen and Fluorine, shows a high chemical and thermal stability, shows a high density, isn't inflammable, has a low surface tension, is soluble only in highly fluoridized solvents, has very good lubricating and dielectric properties, has a low volatility and a good compatibility with plastic materials, elastomers and metals over a large range of temperatures, has a high resistance to the radiation and a low toxicity. Of course there are other oils with the same properties.

The use of this oil allows both to realize the layer without metallization avoiding the undesidered darking of the plastic film and to cover the metallized layer.

To obtain the products subject of the invention one refers to the following process and device which realize them as described as follows.

In a vacuum chamber at the pressure of 10exp-4 torr the plastic pellicle (1) is unwound from the roller (22) and rewound on the roller (24) through the supporting roller (23) (figure 2).

The pellicle can be covered in advance by oil in well delimited zones by means of a device not shown in the figure in the zone between the rotating rollers (22, 23).

The device (20) for the fusion of the metal(s) is made by bars heated at about 1400 °C which provide to the fusion of a wire wound on a reel (case of the Aluminum) or by deposit of metal bars in crucibles heated at about 700 °C electrically or by radiation (case of the Zinc).

The vapors produced by evaporation under vacuum arrive on the pellicle (1) which is made run on the rotating roller (23) and laid themselves down on it forming the semi-finished product (1, 2); the pellicle enriched by this first layer continues towards subsequent metallization in the case of the multi-layers (not shown in the figure) and then towards the evaporation nozzle of the oil to be covered by the oil by forming a thin layer of this and to obtain the final film (10 = 1, 2, 3) (figure 1).

In the case one likes to cover the pellicle over the whole width of the band by a thin layer of oil, one will use as tank/evaporator a tube (31) with a leak (32) of length equal to the whole useable length of the film (figures 3a and 3b).

In the case one likes instead to obtain a different displacement between the free edge of the film with zones without metallization and the cutting line in order to avoid deposit of oil on the cutting line and to easy the fixing of the metal sprayed during the manufacturing of the capacitors (welding of the wires or cables to the headpieces), one shall use a brass tube (41) with sector leak (42) with different pitch with reference to the non-metallized free edge (figures 4a and 4b).

By this process one obtains the dielectric metallized films covered by dielectric protective oil which avoids the penetration of the air and moisture into the interstices between metal and pellicle assuring and improving their capacitance during their operating life.

## Claims

1) Metallized plastic films (10), characterized by the fact that they include a plastic pellicle (1); a metallic layer (2) laid down on at least one side of said pellicle(1); a thin layer of fluid (3, 13) able to penetrate through the roughnesses (11) of said pellicle (1) to avoid the contact and deposit of air/moisture through the interstices created by the particles of said metal laid dowhn through the roughnesses (11) of said pellicle and to fix the metallic layer already on metallizing (figures 1 and 1a).

2) Plastic films according to the claim 1, where the pellicle is previously treated to be made wrinkled, for instance by means of a ionizing treatment.

3) Plastic films according to the claim 1, where the pellicle is polyester.

4) Plastic films according to the claim 1 or 2, where the pellicle is polypropilene.

5) Plastic films according to any one of the claims 1 to 4, where the metallic layer is Super Aluminum.

6) Plastic films according to any one of the claims 1 to 4, where the metallic layer is Super Zinc.

7) Plastic films according to any one of the claims 1 to 4, where the metallic layer is a multi-layer sandwich composite.

8) Plastic films according to any one of the claims 1 to 7, showing well delimited zones without metallization.

9) Plastic films according to any one of the claims 1 to 8, where the fluid is a dielectric lubricant agent of the type of the perfluoridized polyethers with the general formula:

$$CF_3 - ((O - \overset{\overset{CF}{|}}{CF} - CF_2)_m - (O - CF_2)_n) - O - CF_3$$

where m, n = 40.

10) Capacitors obtained by the films according to any one of the claims 1 to 9.

11) Process to realize fully or partially metallized dielectric plastic films according to any one of the claims 1 to 9, characterized by the fact that it includes the following phases:

a) in a vacuum chamber a pellicle (1) is unwound from at least one first supporting roller (22) through a reference roller (23), which supports said pellicle during the metallization and the evaporation of the fluid, to be rewound by at least one second supporting roller (24) (figure 2);

b) by means of at least one meltimg device (20) the metals for the metallization are melted, they vaporize under vacuum and condense fully or partially on at least one side of said pellicle (1) leaving well delimited zones, suitably shielded, without metallization;

c) an evaporator (21) including at least one nozzle delivers an oil layer (3, 13) over the whole useable length of the film on metallizing to fix the metal and to fill up with the particles (12) of the said metal the empty interstices created by the roughnesses (11) of the pellicle (1) (see figure 1a).

12) Process to realize metallized plastic films according to the claim 11, characterized by the fact that the absolute pressure of the vacuum chamber is less than 10exp-4 torr.

13) Process to realize metallized plastic films according to the claim 11, characterized by the fact that the temperature of metallization ranges between 1400 °C and 1450 °C for the Aluminum and between 650 °C and 700 °C for the Zinc.

14) Process to realize metallized plastic films according to the claim 11, characterized by the fact that the temperature of the dielectric oil ranges between 115 °C and 120 °C.

15) Process to realize plastic films according to the claim 11, characterized by the fact that the evaporator

(21) consists of a brass tube (31) (nozzle), acting also as a tank of the fluid on which surface in front of the pellicle (1, 2) a leak (32) is made whose length equals the length of the usable band of the pellicle, in order to obtain an uniform deposit of oil over the whole pellicle; being said tube (31) connected to a second tank (53) through a needle valve (54) allowing a constant amount of fluid in the first tank (31, 41), to provide for a constant distribution of a thin oil layer (3) and fix the metallic layer (2) on said pellicle (1); the evaporation of the said fluid (3) occurs under vacuum in the nozzle/tank (31) itself by means of heating by electrical resistors (50) and thermostat (52) (figures 3a and 5).

16) Process to realize plastic films according to the claim 15, where the leak of the nozzle/tank (41) is executed in sectors (42) of equal or different pitch with reference to the non-metallized free edge, in order not to cover by the thin oil layer the cutting line (metallized or not) of said films (figure 4a).

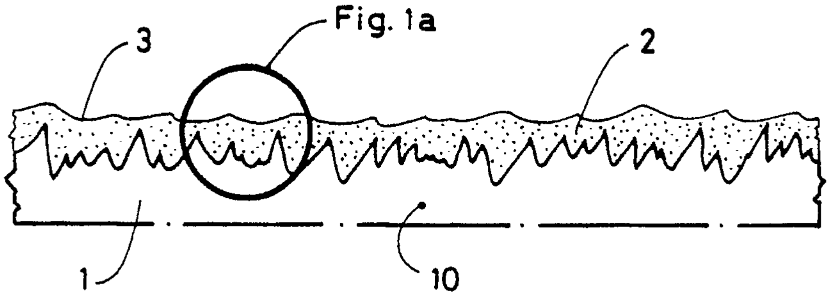


Fig. 1

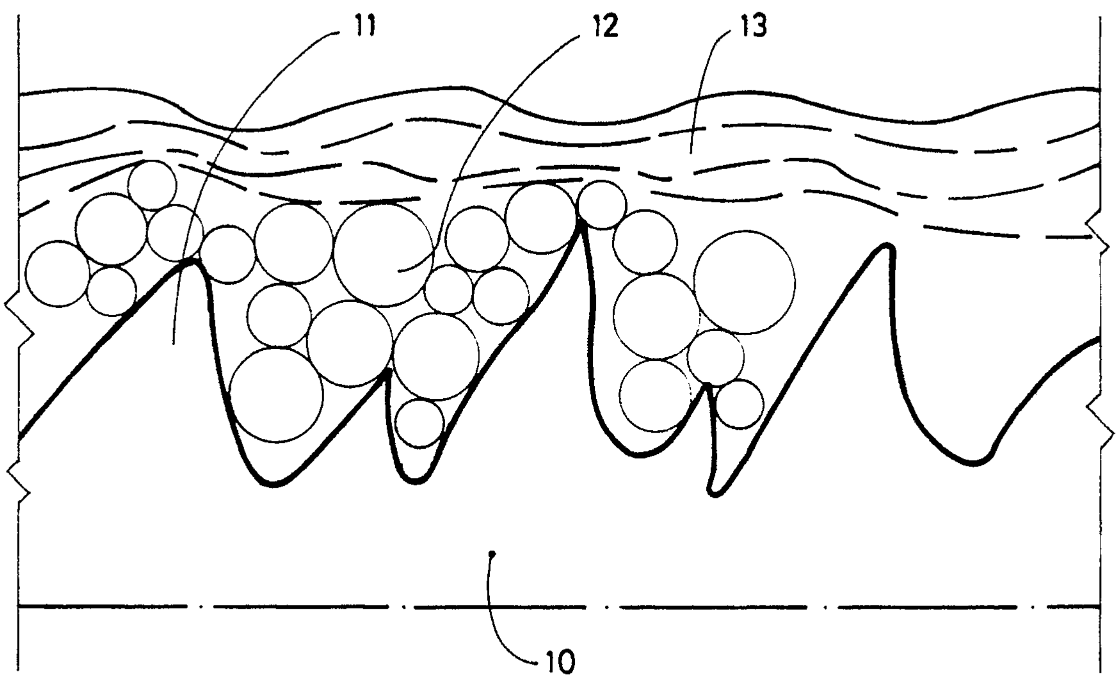


Fig. 1a

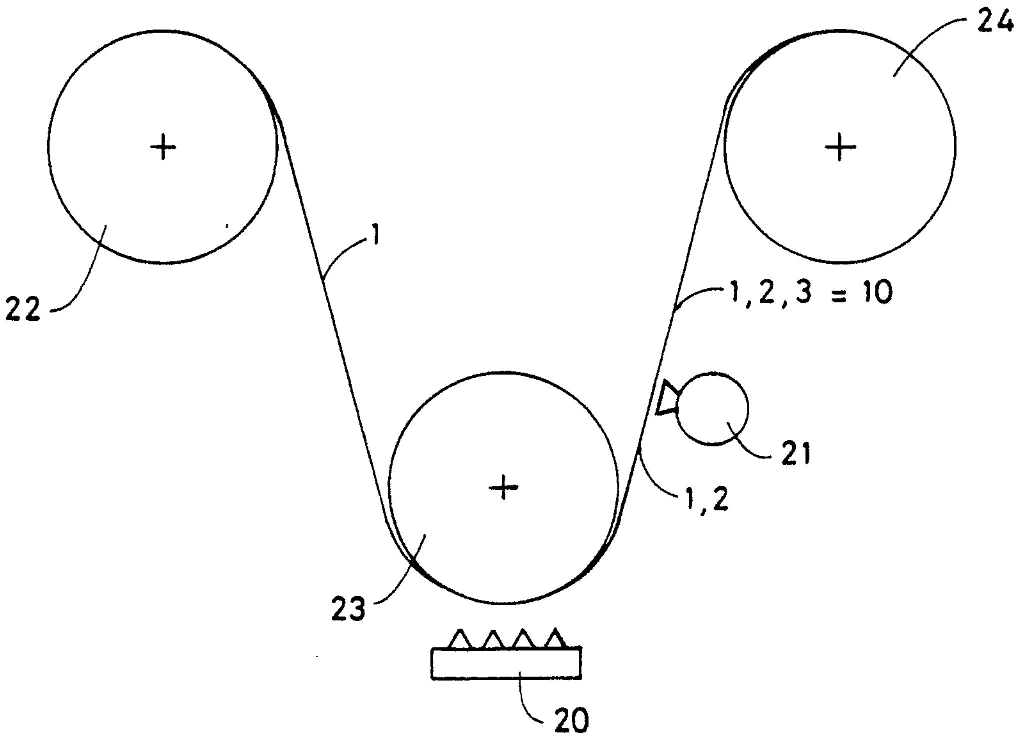


Fig. 2

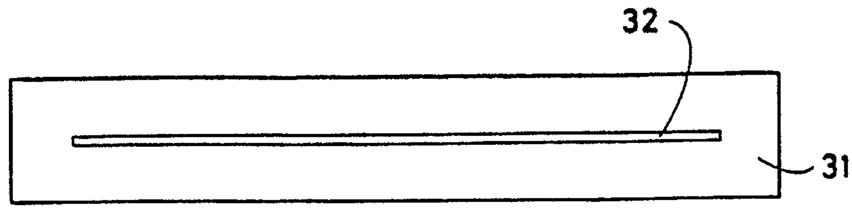


Fig. 3a

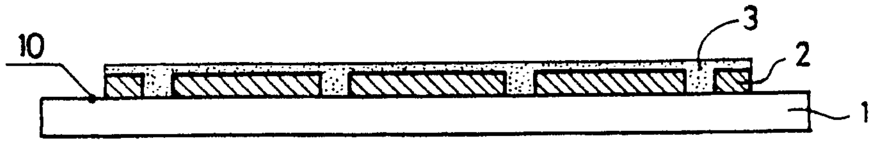


Fig. 3b

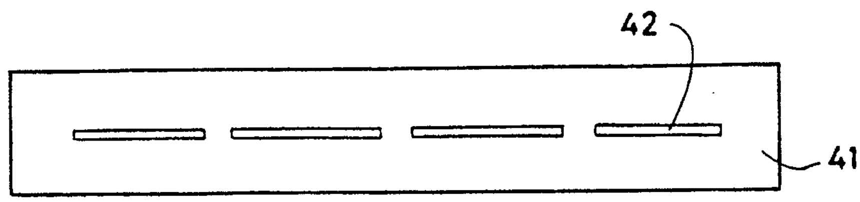


Fig. 4a

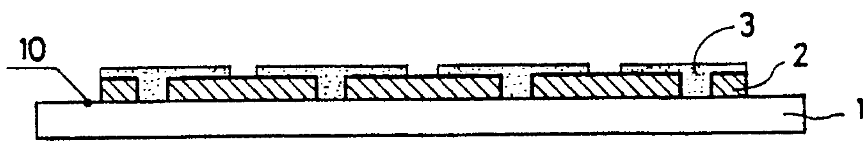


Fig. 4b

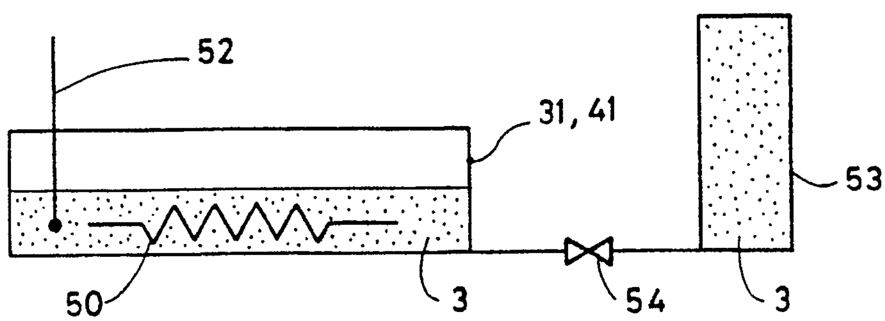


Fig. 5

European Patent Office

# EUROPEAN SEARCH REPORT

Application Number

EP 89 81 0750

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 289 601 (HONSHU SEISHI K.K.) * Figure 1; page 9, paragraph 3 - page 10, paragraph 3; page 8, paragraph 2 * --- | 1-4,10, 11,15 | C 23 C 14/20<br>C 23 C 14/58<br>H 01 G 1/01<br>H 01 G 4/24 |
| A | WO-A-8 800 984 (METAL-VUOTO FILMS S.p.A.) * Claims 1,7,9 * --- | 7,13 | |
| A | EP-A-0 037 235 (EX-CELL-O CORP.) * Claims 1-4 * ----- | 1 | |
| | | | TECHNICAL FIELDS SEARCHED (Int. Cl.5) |
| | | | C 23 C<br>H 01 G |

The present search report has been drawn up for all claims

| Place of search | Date of completion of the search | Examiner |
|---|---|---|
| THE HAGUE | 30-05-1990 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)